# EUROPEAN PATENT APPLICATION

(11) **EP 3 135 798 A1**
(43) Date of publication of application: **01.03.2017**
(21) Application number: 15755275.3
(22) Date of filing: 27.02.2015
(51) Int. Cl.: C30B 29/36

(54) **SILICON CARBIDE CRYSTAL INGOT, SILICON CARBIDE WAFER, AND METHOD FOR MANUFACTURING SILICON CARBIDE CRYSTAL INGOT AND SILICON CARBIDE WAFER**

(30) Priority: 27.02.2014 JP 2014036509
(71) Applicant: Kyocera Corporation, Kyoto-shi, Kyoto 612-8501 (JP)
(72) Inventor: DOMOTO, Chiaki, Kyoto-shi Kyoto 612-8501 (JP); MASAKI, Katsuaki, Kyoto-shi Kyoto 612-8501 (JP); SHIBATA, Kazuya, Kyoto-shi Kyoto 612-8501 (JP); YAMAGUCHI, Shigehiko, Kyoto-shi Kyoto 612-8501 (JP); UEYAMA, Daisuke, Kyoto-shi Kyoto 612-8501 (JP)
(74) Representative: Viering, Jentschura & Partner mbB Patent- und Rechtsanwälte
(86) International application number: PCT/JP2015/055910
(87) International publication number: WO 2015/129876

(57) **Abstract**

A silicon carbide crystal ingot (1) according to one embodiment of the invention includes first crystal layers (3) and second crystal layers (4), each being alternately disposed and all containing one of a donor and acceptor, wherein a concentration of the donor or the acceptor that at least one of the second crystal layers (4) has is higher than a concentration of the donor or the acceptor that one of the first crystal layers (3) has, the one of the first crystal layers being in contact with the at least one of the second crystal layers.

## Description

### Technical Field

The present invention relates to a silicon carbide crystal ingot, a silicon carbide wafer, and methods of producing the silicon carbide crystal ingot and the silicon carbide wafer.

### Background Art

Currently, silicon carbide (SiC) as a material for substrates of electronic components is attracting attention. For example, in Japanese Unexamined Patent Publication JP-A 2012-136391, methods of producing silicon carbide crystal ingot and wafer which become a substrate of an electronic component are disclosed.

Such methods of producing silicon carbide crystal ingot and wafer are intended to manufacture a high-purity silicon carbide crystal.

However, if silicon carbide crystal is simply formed to have a high purity, for example, an amount of a donor or acceptor in a wafer, which becomes a substrate of an electronic component, is small and also an electric resistance of the substrate is increased. As a result, performance of the electronic component is likely to be degraded.

Further, if silicon carbide crystal is formed to have a high purity, a crystal growth history is less prone to be left in the silicon carbide crystal ingot and wafer. As a result, when the crystal ingot or wafer is defective, a deficiency in a production process of the ingot or wafer is less prone to be presumed.

The invention has been devised in view of the above problems, and an object thereof is to provide a silicon carbide crystal ingot and a silicon carbide wafer in which performance of an electronic component can be enhanced or a deficiency in a production process thereof can be presumed.

### Summary of Invention

A silicon carbide crystal ingot according to one embodiment includes first crystal layers and second crystal layers, each being alternately disposed and all containing one of a donor and an acceptor, wherein a concentration of the donor or the acceptor that at least one of the second crystal layers has is higher than a concentration of the donor or the acceptor that one of the first crystal layers has, the one of the first crystal layers being in contact with the at least one of the second crystal layers.

A silicon carbide wafer according to one embodiment includes first crystal layers and second crystal layers, each being alternately disposed and all containing one of a donor and an acceptor, a concentration of the donor or the acceptor that at least one of the second crystal layers has is higher than a concentration of the donor or the acceptor that one of the first crystal layers has, the one of the first crystal layers being in contact with the at least one of the second crystal layers.

A silicon carbide crystal ingot according to one embodiment includes first crystal layers and second crystal layers, each being alternately disposed in a crystal grown direction, wherein a color tone of at least one of the second crystal layers is darker than a color tone of one of the first crystal layers being in contact with the at least one of the second crystal layers.

A silicon carbide wafer according to one embodiment includes first crystal layers and second crystal layers, each being alternately disposed, wherein a color tone of at least one of the second crystal layers is darker than a color tone of one of the first crystal layers being in contact with the at least one of the second crystal layers.

According to the silicon carbide crystal ingot and the silicon carbide wafer according to one embodiment of the invention, performance of an electronic component can be enhanced or a deficiency in a production process thereof can be presumed.

### Brief Description of Drawings

FIG. 1 is a schematic side view showing a silicon carbide crystal ingot according to one embodiment of the invention;
FIG. 2 is a schematic enlarged sectional view showing a silicon carbide crystal ingot according to one embodiment of the invention;
FIG. 3 is a schematic enlarged sectional view showing a silicon carbide crystal ingot according to one embodiment of the invention;
FIG. 4 is a schematic sectional view showing a silicon carbide crystal ingot according to one embodiment of the invention;
FIG. 5 is a schematic enlarged sectional view showing a silicon carbide crystal ingot according to one embodiment of the invention;
FIG. 6 is a schematic enlarged sectional view showing a silicon carbide crystal ingot according to one embodiment of the invention;
FIG. 7 is a schematic side view showing a silicon carbide crystal wafer according to one embodiment of the invention;
FIG. 8 is a schematic enlarged sectional view showing a silicon carbide wafer according to one embodiment of the invention; and
FIG. 9 is a sectional view showing one example of a crystal production apparatus used for a silicon carbide crystal ingot according to one embodiment of the invention.

### Description of Embodiments

### <Silicon Carbide Crystal Ingot>

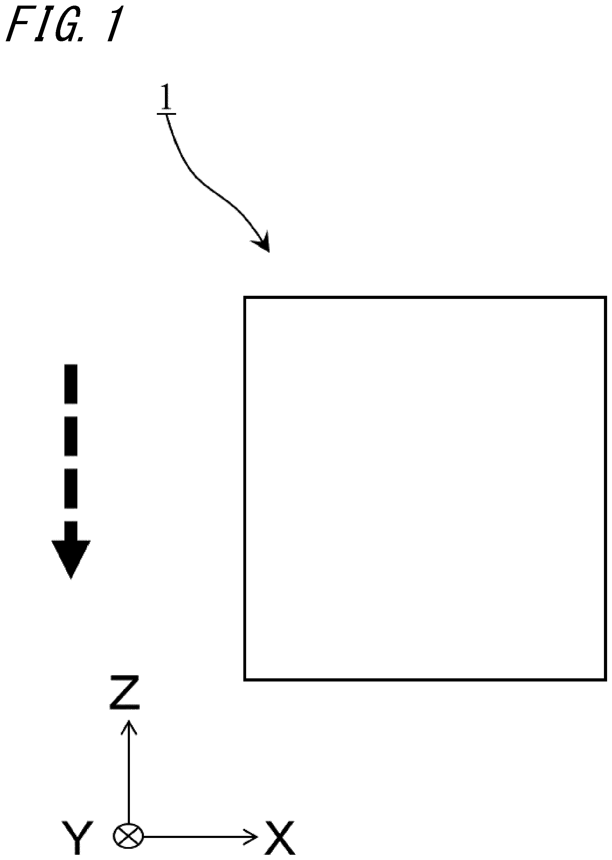

Hereinafter, a silicon carbide crystal ingot according to one embodiment of the invention will be described with reference to FIGS. 1 to 6. Meanwhile, the invention is not limited to the present embodiment, and thus various changes, modifications and the like are possible without departing from the scope of the invention.

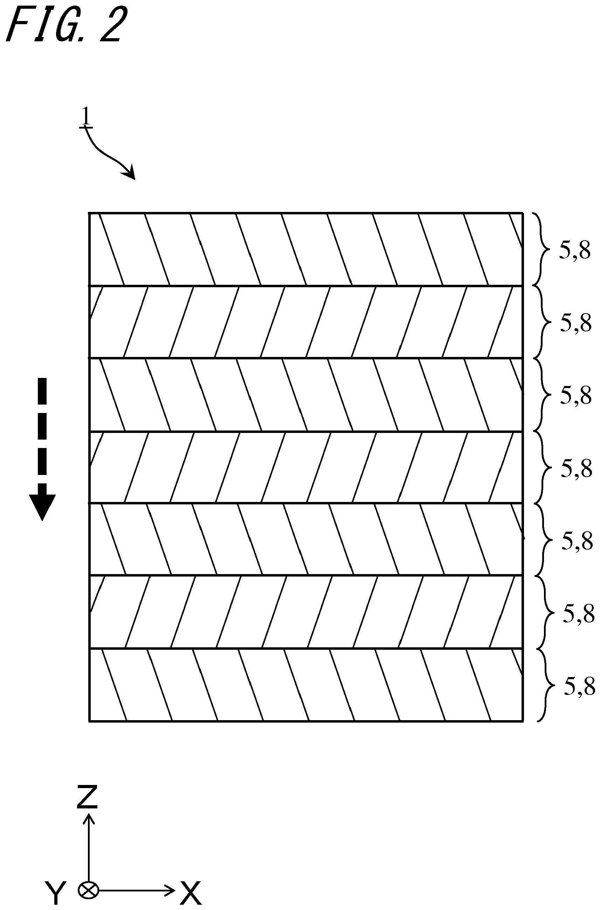

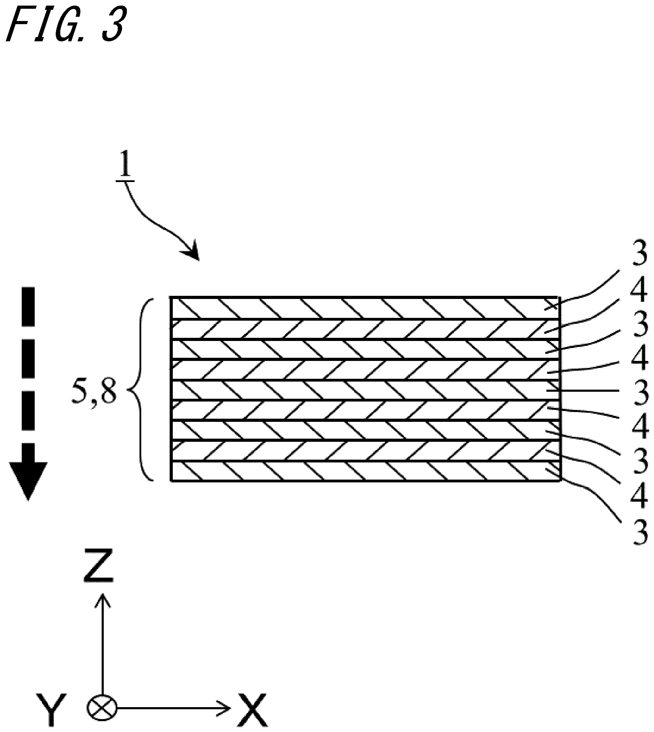

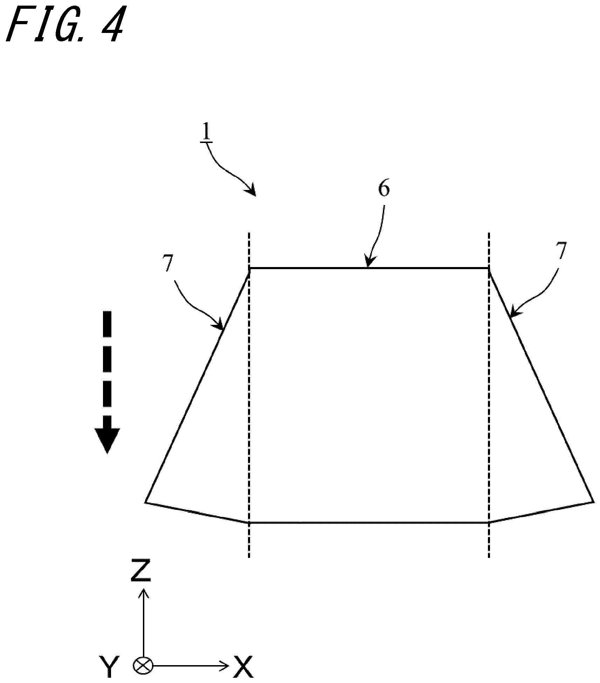

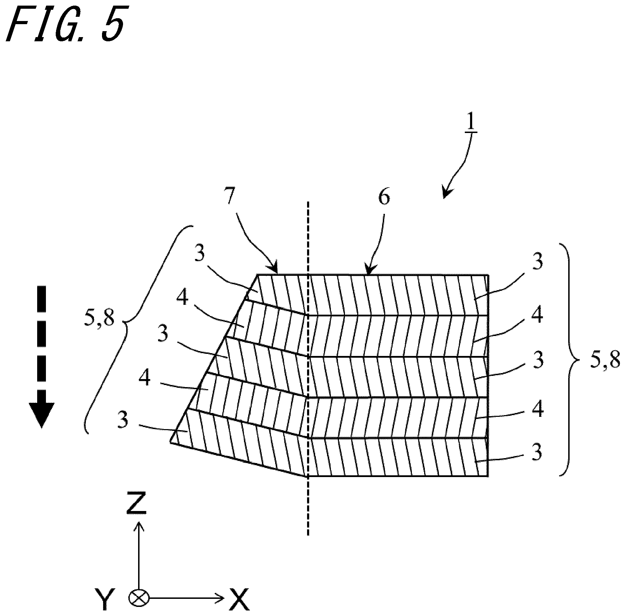

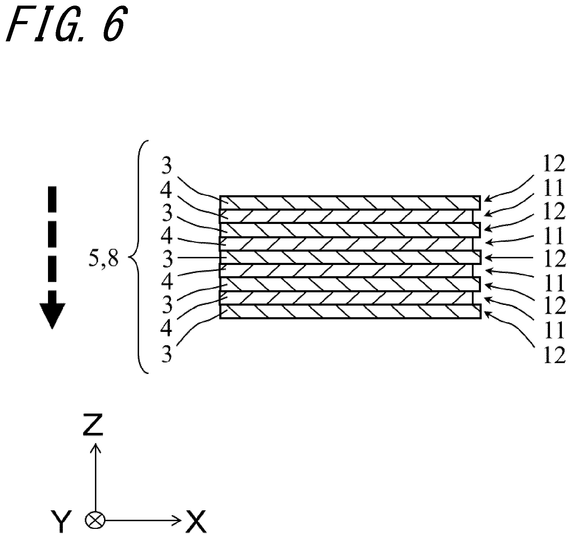

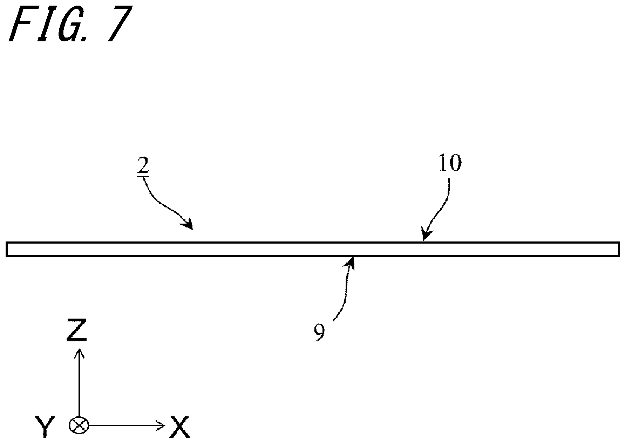

FIG. 1 is a schematic side view showing a silicon carbide crystal ingot according to one embodiment of the invention. FIG. 2 is an enlarged sectional view showing a part of a cross section of the ingot shown in FIG. 1, as cut along a vertical direction (Z-axis direction), illustrating a donor or acceptor concentration in the ingot and color tones of the ingot. FIG. 3 is a further enlarged sectional view showing the part of the cross section of the ingot shown in FIG. 2, illustrating a donor or acceptor concentration in the ingot and color tones of the ingot. FIG. 4 is a schematic side view showing an ingot according to an embodiment different from the ingot shown in FIG. 1. FIG. 5 is an enlarged sectional view showing a part of a cross section of the ingot shown in FIG. 4, as cut along the vertical direction, illustrating a donor or acceptor concentration in the ingot and color tones of the ingot. FIG. 6 is an enlarged sectional view showing a part of a cross section of an ingot according to an embodiment different from the ingots shown in FIGS. 1 and 4, as cut along the vertical direction, illustrating a donor or acceptor concentration in the ingot and a side shape of the ingot. Also, FIG. 7 is a schematic side view showing a silicon carbide crystal wafer according to one embodiment of the invention.

An ingot 1 is machined into wafers 2. Then, the wafers 2 become a part of electric components, such as a transistor or a diode, through a production process for semiconductor components. The ingot 1 is formed of silicon carbide crystal. For example, the ingot 1 is formed in a plate or columnar shape. A planar shape of the ingot 1 is, for example, a circular or polygonal shape. In the present embodiment, the ingot 1 is formed in a columnar shape as shown in FIG. 1 and a planar shape of the ingot 1 is a circular shape. Namely, the shape of the ingot 1 is a circular columnar shape. In addition, for example, 45 pieces or more and 225 pieces or less of wafers 2 are obtained from one ingot 1.

Meanwhile, a downward dotted line arrow shown in FIG. 1 represents a crystal growth direction. Also, the same is applied to FIGS. 2, 3 and 6.

A height of the ingot 1 is set, for example, to 30 mm or more and 150 mm or less. A diameter of the ingot 1 is set, for example, to 75 mm or more and 210 mm or less. The height and diameter of the ingot 1 can be measured, for example, using a vernier caliper.

As shown in FIG. 3, the ingot 1 has a plurality of first crystal layers 3 and a plurality of second crystal layers 4. The ingot 1 is formed so that the plurality of first crystal layers 3 and the plurality of second crystal layers 4 are alternately disposed for every one layer. The first crystal layers 3 and the second crystal layers 4 means layer-shaped portions formed in the ingot 1. Like the ingot 1, a planar shape of the first crystal layers 3 and the second crystal layers 4 are, for example, a circular or polygonal planar shape. In the present embodiment, a planar shape of the first crystal layers 3 and the second crystal layers 4 is, for example, a circular planar shape.

Each of the plurality of first crystal layers 3 and the plurality of second crystal layers 4 contains a donor or acceptor. As donors to be contained in the first crystal layers 3 and the second crystal layers 4, materials such as nitrogen (N), phosphorus (P) or arsenic (As) are selected. As acceptors to be contained in the first crystal layers 3 and the second crystal layers 4, materials such as aluminum (Al), boron (B) or gallium (Ga) are selected. Meanwhile, depending on types and usage of electronic components, whether a donor or acceptor is doped into the first crystal layers 3 and the second crystal layers 4 are appropriately selected.

A thickness of one layer of the first crystal layers 3 is set, for example, to 3 µm or more and 300 µm or less. A thickness of one layer of the second crystal layers 4 is set, for example, to 3 µm or more and 300 µm or less. Because the first crystal layers 3 and the second crystal layers 4 have a sufficient thin thickness as described above, when the ingot 1 is machined into wafers 2, each wafer 2 has the plurality of first crystal layers 3 and the plurality of second crystal layers 4. Meanwhile, a thickness of each of the first crystal layers 3 or each of the second crystal layers 4 can be measured, for example, from a cross section of the first crystal layers 3 or the second crystal layers 4 using an optical microscope. Also, diameters of the first crystal layers 3 and the second crystal layers 4 are the same as the diameter of the ingot 1.

A donor or acceptor concentration in each of the plurality of the second crystal layers 4 is higher than a donor or acceptor concentration in the first crystal layer 3 which is in contact with the second crystal layer 4 from above or below. Accordingly, a conductivity of the second crystal layer 4 is higher than a conductivity of the first crystal layer 3. As a result, in a case where an electronic component is manufactured by a wafer 2 sliced from the ingot 1, the wafer 2, which becomes a substrate, has a plurality of second crystal layers 4, in which a concentration of donors or the like is higher, so that the substrate, which constitutes the electronic component, can have a low electric resistance. Therefore, performance of the electronic component can be enhanced.

Also, the ingot 1 includes the first crystal layers 3 in which a donor or acceptor concentration is lower than a donor or acceptor concentration in the second crystal layers 4. As a result, for example, when a wafer 2 sliced from the ingot 1 is manufactured, whether a surface of the wafer 2 is formed of the first crystal layer 3 or the second crystal layer 4 can be selected depending on a lattice constant of an epitaxial layer to be grown on the wafer 2. Therefore, for example, choices for materials of the epitaxial layer to be grown on the wafer 2 are increased, thereby enhancing versatility of the ingot 1.

The first crystal layers 3 contain a donor or acceptor so that a carrier density of the first crystal layers 3 is, for example, 1×10¹⁸ carriers/cm³ or more and 5×10¹⁸ carriers/cm³ or less. The second crystal layers 4 contain a donor or acceptor so that a carrier density of the second crystal layers 4 is higher than the carrier density of the first crystal layer 3 and also is 1×10²⁰ carriers/cm³ or less. Meanwhile, the carrier densities of the first crystal layers 3 and the second crystal layers 4 can be measured, for example, by a carrier concentration measurement, using a Hall effect.

Further, the carrier density of the second crystal layers 4 is set, for example, to 1.1 times or more and 10 times or less of the carrier density of the first crystal layers 3. By setting the carrier density of the second crystal layers 4 to be 1.1 times or more of the carrier density of the first crystal layers 3, conductivity of the ingot 1 can be effectively enhanced. Also, by setting the carrier density of the second crystal layers 4 to be 10 times or less of the carrier density of the first crystal layers 3, occurrence of defects in the second crystal layers 4 can be reduced.

The plurality of first crystal layers 3 and the plurality of second crystal layers 4 may be cyclically disposed. Namely, the plurality of second crystal layers 4 and the plurality of first crystal layers 3 may be regularly alternately disposed. As a result, unevenness in quality for each of a plurality of wafers 2 manufactured from the ingot 1 can be reduced.

As shown in FIG. 2, the ingot 1 may have a concentration gradient portion 5 in which a donor or acceptor concentration is increasing as it approaches to a lower surface of the ingot 1. In the present embodiment, a donor or acceptor concentration in the plurality of first crystal layers 3 and the plurality of second crystal layers 4 in the concentration gradient portion 5 is increasing as a location of each of the first crystal layers 3 or each of the second crystal layers 4 progresses along a crystal growth direction. In other words, a donor or acceptor concentration in any one first crystal layer 3 in one concentration gradient portion 5 is higher than a donor or acceptor concentration in other first crystal layers 3 located above. Also, a donor or acceptor concentration in any one second crystal layer 4 in one concentration gradient portion 5 is higher than a donor or acceptor concentration in other second crystal layers 3 located above. Namely, because the plurality of first crystal layers 3 and the plurality of second crystal layers 4 are included, a donor or acceptor concentration in the concentration gradient portion 5 microscopically increases or decreases, but as a whole, is gradually increasing as it approaches to the lower surface. Due to this configuration, a lattice constant of the surface of the wafer 2 can be controlled, and for example, choices for materials of an epitaxial layer to be grown on the wafer 2 are increased. As a result, versatility of the ingot 1 can be enhanced.

A carrier density of the concentration gradient portion 5 is set, for example, to 1×10¹⁸ carriers/cm³ or more and 1×10²⁰ carriers/cm³ or less. More preferably, the carrier density of the concentration gradient portion 5 is set, for example, to 5×10¹⁸ carriers/cm³ or more and 1×10¹⁹ carriers/cm³ or less. If the carrier density of the concentration gradient portion 5 is 5×10¹⁸ carriers/cm³ or more, conductivity of the ingot 1 can be effectively enhanced. Also, if the carrier density of the concentration gradient portion 5 is 1×10¹⁹ carriers/cm³ or less, occurrence of defects in the ingot 1 can be reduced.

The ingot 1 may have a plurality of concentration gradient portions 5. In addition, the plurality of concentration gradient portions 5 may exist separately from each other in the crystal growth direction or may be continuous in the crystal growth direction. In this way, the concentration gradient portions 5 can be included in the plurality of wafers 2, and also portions in which a lattice constant is gradually varied can be formed in the plurality of wafers 2. Accordingly, the plurality of wafers 2 having a higher versatility can be manufactured from the ingot 1.

A thickness of each of the concentration gradient portions 5 is set, for example, to 500 µm or more and 900 µm or less. Also, the numbers of concentration gradient portions 5 is set, for example, to 1/2 times or more and 2 times or less of the number of wafers 2 to be sliced from one ingot 1. Further, the plurality of concentration gradient portions 5 are disposed at a distance of 1.2 mm or less from each other.

The concentration gradient portions 5 may be continuous in the crystal growth direction. In this case, for example, if wafers 2 are sliced from the ingot 1 in accordance with the concentration gradient portions 5, unevenness in quality for each wafer 2 can be reduced.

As shown in FIG. 4, the ingot 1 may has a middle portion 6 located in the middle thereof and a peripheral portion 7 whose diameter is enlarged according to the crystal growth direction. Also, as shown in FIG. 5, part of the plurality of first crystal layers 3 and the plurality of second crystal layers 4 constituting the peripheral portion 7 may be inclined to the crystal growth direction in the middle portion. Therefore, for example, in a case where cylindrical grinding is performed upon slicing of wafers 2, the grinding can be performed considering as a reference line a boundary between the peripheral portion 7 and the middle portion 6. As a result, work efficiency can be enhanced. Meanwhile, if a seed crystal exists, the middle portion 6 is a portion located below the seed crystal and the peripheral portion 7 is a portion having a width wider than a lower surface of the seed crystal.

In addition, each part of the plurality of first crystal layers 3 and the plurality of second crystal layers 4 constituting the peripheral portion 7 is inclined, for example, in a range of 50° or more and 80° or less to a face of each of the plurality of first crystal layers 3 and the plurality of second crystal layers 4 in the middle portion 6.

Meanwhile, dashed lines shown in FIGS. 4 and 5 are intended to distinguish between the middle portion 6 and the peripheral portion 7 and are shown in the figures for convenience sake. Also, downward dotted lines shown in FIGS. 4 and 5 represent the crystal growth direction in the middle portion 6.

A donor or acceptor concentration in the part of the plurality of first crystal layers 3 and the plurality of second crystal layers 4 constituting the peripheral portion 7 may be lower than a donor or acceptor concentration in an inside part of the first crystal layers 3 and the second crystal layers 4. Due to this configuration, the peripheral portion 7 has a higher strength than that of the middle portion 6, thereby allowing the ingot 1 to be hardly cracked. As a result, a decrease in production efficiency due to cracking or chipping in the ingot 1 can be reduced.

In addition, a carrier density of the peripheral portion 7 is set, for example, to 1×10¹⁶ carriers/cm³ or more and 3×10¹⁸ carriers/cm³ or less. In particular, the carrier density of the peripheral portion 7 is preferably set to be 5×10¹⁷ carriers/cm³ or more and 2×10¹⁸ carriers/cm³ or less. By setting the carrier density of the peripheral portion 7 to be 5×10¹⁷ carriers/cm³ or more, for example, a difference in carrier density from the middle portion 6 can be reduced and thus occurrence of cracking and the like in the ingot 1 during machining thereof can be reduced. Also, by setting the carrier density of the peripheral portion 7 to be 2×10¹⁸ carriers/cm³ or less, for example, the middle portion 6 and the peripheral portion 7 can be easily distinguished from each other.

A thickness of each of the first crystal layers 3 may be smaller (thinner) than a thickness of each of the second crystal layers 4. In this case, when the ingot 1 is machined into wafers 2, a proportion of the second crystal layers 4 in the ingot 1 is increased. As a result, the ingot 1 formed of silicon carbide crystal is allowed to be easily machined. Meanwhile, at this time, the thickness of the first crystal layers 3 is set, for example, to 50% or more and 70% or less of the thickness of the second crystal layers 4.

An upper surface of the ingot 1 may be formed of the first crystal layer 3. In this case, the ingot 1 is formed on the lower surface of the seed crystal 101 by a crystal production apparatus 100, as described below, but because the upper surface of the ingot 1 is formed of the first crystal layer 3 having a small lattice constant, a strain between the ingot 1 and the seed crystal 101 can be reduced.

A lower surface of the ingot 1 may be formed of the first crystal layer 3. In this case, a lower portion of the ingot 1 is cut off and then the cut lower portion of the ingot 1 can be used as a seed crystal 101 upon producing of the next ingot 1. Thus, because a quality of the ingot 1 is influenced by a quality of the seed crystal 101, unevenness in quality among a plurality of ingots 1 can be reduced.

As shown in FIG. 6, a plurality of recesses 11 and a plurality of protrusions 12 are continuously formed on a side surface of the ingot 1. In this case, a surface area of the side surface of the ingot 1 can be increased so that the ingot 1 can easily emit heat, thereby enhancing a growth rate of the ingot 1. Meanwhile, in the present embodiment, the plurality of recesses 11 and the plurality of protrusions 12 are formed to correspond to the plurality of first crystal layers 3 and the plurality of second crystal layers 4. Meanwhile, in FIG. 6, one side surface of the ingot 1 is shown on the right side in the figure. In addition, a depth of the recesses 11 is set, for example, to 25 µm or more and 100 µm or less. Also, a height of the protrusions 12 is set, for example, to 25 µm or more and 100 µm or less.

Further, in the ingot 1, a color tone of each of the plurality of second crystal layers 4 is darker than a color tone of the first crystal layer 3 which is in contact with the second crystal layer 4 from above or below. Namely, a stripped pattern is formed on the ingot 1 due to a difference in color tone between the plurality of first crystal layers 3 and the plurality of second crystal layers 4. This means that a crystal growth history is left in a visible state in the ingot 1, and accordingly, for example, when the ingot 1 is defective, a deficiency in the production process thereof can be presumed by checking a variation in color tone.

Meanwhile, in the present embodiment, a color tone of the plurality of first crystal layers 3 and a color tone of the plurality of second crystal layers 4 are varied from each other by varying a concentration of impurities, such as a donor or acceptor, between the plurality of first crystal layers 3 and the plurality of second crystal layers 4. Also, in the present embodiment, color tones of crystal layers can be identified by an optical microscope. Alternatively, although in the present embodiment, a variation in color tone between the plurality of first crystal layers 3 and the plurality of second crystal layers 4 is imparted by varying a donor or acceptor concentration, a variation in color tone may be imparted by simultaneously implanting donors and acceptors. Also, a variation in color tone may be imparted by implanting impurities, other than, for example, a donor or acceptor, into the ingot 1.

Further, in the ingot 1 according to the present embodiment, when light is illuminated thereon, a portion, which has a high impurity concentration, can be recognized as a color from dark brown to brown, and also a portion, which has a low impurity concentration, can be recognized as a color from brown to ocher. Namely, in the ingot 1, transmittance of light is varied depending on an impurity concentration and thus a variation in tone of similar colors due to influence of the impurity concentration can be identified. Meanwhile, a color when light is illuminated is also varied depending on the polytype of crystal of the ingot 1. For example, if the polytype of crystal of the ingot 1 is 4H, the ingot 1 has a color tone in a brown family, and if the polytype is 6H, the ingot 1 has a color tone in a green family. Thus, by identifying a color of the ingot 1, the polytype of crystal can be also identified.

As shown in FIG. 2, the ingot 1 may have a color tone gradient portion 8 in which a color tone is darkened as it goes toward the lower surface of the ingot 1. In the present embodiment, color tones of the plurality of first crystal layers 3 and the plurality of second crystal layers 4 in the color tone gradient portion 8 are darkened as a location of each of the first crystal layers 3 or each of the second crystal layers 4 progresses along a crystal growth direction. In other words, a color tone of any one first crystal layer 3 in one color tone gradient portion 8 is darker than a color tone of other first crystal layers 3 located above. Also, a color tone of any one second crystal layer 4 in one color tone gradient portion 8 is darker than a color tone of other second crystal layers 3 located above. Namely, because the plurality of first crystal layers 3 and the plurality of second crystal layers 4 are included, color tones in the color tone gradient portion 8 is microscopically darkened or lightened, but as a whole, is gradually darkened as it goes toward the lower surface. In this case, a lattice constant of crystal can be gradually varied. Also, by adjusting an impurity concentration on a surface of a wafer 2 to correspond to an impurity concentration of an epitaxial layer to be formed on the wafer 2, quality of an epitaxial crystal upon forming of the epitaxial layer can be enhanced.

A thickness of the color tone gradient portion 8 is set, for example, to 500 µm or more and 900 µm or less. Also, the color tone gradient portion 8 is formed to include color tones, for example, from ocher to dark brown.

The ingot 1 may include a plurality of color tone gradient portions 8 along the crystal growth direction. In addition, the plurality of color tone gradient portions 8 may exist separately from each other in the crystal growth direction or may be continuous in the crystal growth direction. In this way, the concentration gradient portions 5 can be included in the plurality of wafers 2, and also portions in which a lattice constant is gradually varied can be formed in the plurality of wafers 2. Accordingly, the plurality of wafers 2 having a higher versatility can be manufactured from the ingot 1.

Also, the numbers of concentration gradient portions 5 is set, for example, to 1/2 times or more and 2 times or less of the numbers of wafers 2 to be sliced from one ingot 1. Further, the plurality of concentration gradient portions 5 are arranged at a distance of 1.2 mm or less from each other.

Among others, a plurality of color tone gradient portions 8 are preferably provided to be continuous in the crystal growth direction. In this case, for example, if wafers 2 are sliced from the ingot 1 in accordance with the color tone gradient portions 8, unevenness in quality for each wafer 2 can be reduced.

A color tone of the part of the plurality of first crystal layers 3 and the plurality of second crystal layers 4 constituting the peripheral portion 7 may be lighter than a color tone of an inside part of the first crystal layers 3 and the second crystal layers 4. In this case, because an amount of impurities in the peripheral portion 7 is less than an amount of impurities in an inside portion, a hardness of crystal in the peripheral portion 7 is increased, thereby allowing the ingot 1 to be less prone to be cracked. In addition, because an impurity concentration of the peripheral portion 7 is smaller than an impurity concentration of the middle portion 6, the peripheral portion 7 has a transparency higher than that of the middle portion 6 and thus a brown color lighter than that of the middle portion 6.

Also, part of the plurality of first crystal layers 3 and the plurality of second crystal layers 4 constituting the peripheral portion 7 may be inclined to the crystal growth direction in the middle portion 6. Therefore, for example, in a case where cylindrical grinding is performed upon slicing of wafers 2, the grinding can be performed considering as a reference line a boundary between the peripheral portion 7 and the middle portion 6. As a result, work efficiency can be enhanced.

### <Silicon Carbide Wafer>

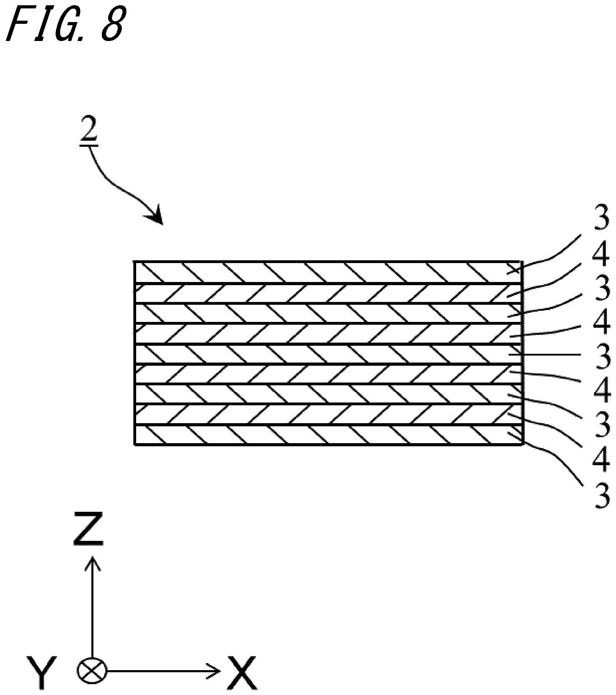

Next, a silicon carbide wafer according to one embodiment of the invention will be described with reference to FIGS. 7 and 8. Meanwhile, the invention is not limited to the present embodiment, and thus various changes, modifications and the like are possible without departing from the scope of the invention.

FIG. 8 is an enlarged sectional view showing a part of a cross section of a wafer shown in FIG. 7, as cut along a vertical direction, illustrating a donor or acceptor concentration in the wafer and color tones of the wafer.

A wafer 2 becomes, for example, a substrate for an electronic component. As shown in FIG. 7, the wafer 2 is formed in a plate shape and has a first principal surface 9 and a second principal surface 10 opposite to the first principal surface 9. A planar shape of the wafer is, for example, a circular or polygonal shape. A thickness of the wafer 2 is set, for example, to 350 µm or more and 600 µm or less.

The wafer 2 has a plurality of first crystal layers 3 and a plurality of second crystal layers 4. As shown in FIG. 8, the wafer 2 is configured so that the plurality of first crystal layers 3 and the plurality of second crystal layers 4 are alternately disposed for every one layer. In addition, a donor or acceptor concentration in each of the plurality of second crystal layers 4 is higher than a donor or acceptor concentration in the first crystal layer 3 which is in contact with the second crystal layer 4 from above or below. Accordingly, conductivity of the second crystal layer 4 is higher than conductivity of the first crystal layer 3. As a result, the wafer 2 serving as the substrate has a plurality of second crystal layers 4, in which a concentration of donors or the like is higher, so that the substrate, which constitutes the electronic component, can have a low electric resistance. Therefore, performance of the electronic component can be enhanced.

Further, a resistivity of the first crystal layers 3 is set, for example, to 15 mΩ·cm or less. Also, a resistivity of the second crystal layers 4 is set, for example, to 20 mΩ·cm or less. In addition, a difference between the resistivity of the second crystal layers 4 and the resistivity of the first crystal layers 3 is set, for example, to 1 mΩ·cm or more and 15 mΩ·cm or less. If the resistivities of the first crystal layers 3 and the second crystal layers 4 are set to 20 mΩ·cm or less, performance of the electronic component can be easily ensured.

Also, the wafer 2 includes the first crystal layers 3 in which a donor or acceptor concentration is lower than a donor or acceptor concentration in the second crystal layers 4. As a result, when an epitaxial layer is grown on the wafer 2, the first crystal layer 3 in which a concentration of donors or the like is low and a lattice constant is close to that of the epitaxial layer, can be used as a base. Therefore, occurrence of a strain, dislocation or the like due to a difference in lattice constant of the epitaxial layer can be reduced.

In the wafer 2, a donor or acceptor concentration in a first crystal layer 3 and a second crystal layer 4 which are located closer to the first principal surface 9 may be higher than a donor or acceptor concentration in a first crystal layer 3 and a second crystal layer 4 which are located closer to the second principal surface 10. In this case, upon production of an electronic component, for example, when a SiC epitaxial layer is formed, quality of the epitaxial layer can be enhanced if the epitaxial layer is formed on the first principal surface 9, because they have lattice constants close to each other. On the other hand, because a portion located closer to the second principal surface 10 has a higher donor or acceptor concentration, an electric resistance of a substrate of the electronic component can be decreased.

Further, in this case, the donor or acceptor concentration in the first crystal layer 3 and the second crystal layer 4 which are located closer to the first principal surface 9 is set, for example, to be 1.1 times or more and 10 times or less of the donor or acceptor concentration in the first crystal layer 3 and the second crystal layer 4 which are located closer to the second principal surface 10.

A donor or acceptor concentration in the plurality of first crystal layers 3 and the plurality of second crystal layers 4 may be increasing as each of the plurality of first crystal layers 3 or each of the plurality of second crystal layers 4 approaches to the first principal surface 9. In this case, a lattice constant can be gradually varied and thus an internal stress of the wafer 2 can be reduced.

A donor or acceptor concentration in the first crystal layers 3 and the second crystal layers 4 which are located closer to the first principal surface 9 and a donor or acceptor concentration in the first crystal layers 3 and the second crystal layers 4 which are located closer to the second principal surface 10 may be lower than a donor or acceptor concentration in a first crystal layer 3 and a second crystal layer 4 which are located in the middle in a thickness direction thereof. In this case, a difference in impurity concentration between a portion located closer to the first principal surface 9 and a portion located closer to the second principal surface 10 can be reduced, and for example, upon production of the electronic component, when a high temperature processing is performed, a strain of the substrate due to a difference in linear expansion coefficient can be reduced.

In this case, the donor or acceptor concentration in the first crystal layer 3 and the second crystal layer 4 which are located in the middle of the thickness direction is set, for example, to be 1.1 times or more and 10 times or less of a donor or acceptor concentration in the first crystal layers 3 and the second crystal layers 4 which are located closer to the first principal surface 9 and the second principal surfaces 10.

A color tone of each of the plurality of second crystal layers 4 is darker than a color tone of a first crystal layer 3 that is in contact therewith from above or below. Namely, a stripped pattern is formed on the wafer 2 due to a difference in color tone between the plurality of first crystal layers 3 and the plurality of second crystal layers 4. As a result, a deficiency in the production process thereof can be presumed by checking a variation in color tone.

The plurality of second crystal layers 4 and the plurality of first crystal layers 3 may be cyclically arranged. Namely, the plurality of second crystal layers 4 and the plurality of first crystal layers 3 may be regularly alternately disposed. As a result, unevenness in quality for each of the plurality of wafers 2 manufactured from an ingot 1 can be reduced.

A color tone of each of the first crystal layer 3 and the second crystal layer 4 which are located closer to the first principal surface 9 may be respectively darker than a color tone of each of the first crystal layer 3 and the second crystal layer 4 which are located closer to the second principal surface 10. In this case, because a difference in color tone in the wafer 2 is caused, for example, due to a difference in kind of impurity or a difference in amount of impurity, the first principal surface 9 and the second principal surface 10 have different lattice constants. As a result, depending on a material of an epitaxial layer, the epitaxial layer can be formed on the first principal surface 9 or the second principal surface 10 which has a lattice constant closer to that thereof, thereby enhancing versatility of the wafer 2.

A color tone of the plurality of first crystal layers 3 and a color tone of the plurality of second crystal layers 4 may be darkened as a location of each of the first crystal layers 3 and the second crystal layers 4 approaches to the first principal surface 9. In this case, a lattice constant can be gradually varied in the thickness direction of the wafer 2, and thus an internal stress of the wafer 2 can be reduced.

The color tone of the plurality of first crystal layers 3 and the color tone of the plurality of second crystal layers 4 may be darkened as a location of each of the first crystal layers 3 and the second crystal layers 4 approaches from the second principal surface 10 toward the first principal surface 9, suddenly lightened on the way and then again darkened as the location approaches to the first principal surface 9. In this case, because a difference in color tone in the wafer 2 is caused, for example, due to a difference in amount of impurity, an impurity concentration is increased in the interior of the wafer 2 and is decreased in portions closer to the first principal surface 9 and the second principal surface 10. As a result, for example, upon production of the electronic component, when a high temperature processing is performed, a difference in thermal expansion between the portion located closer to the first principal surface 9 and the portion located closer to the second principal surface 10 can be decreased and thus a strain of the substrate due to thermal expansion can be reduced.

### <Crystal Production Apparatus>

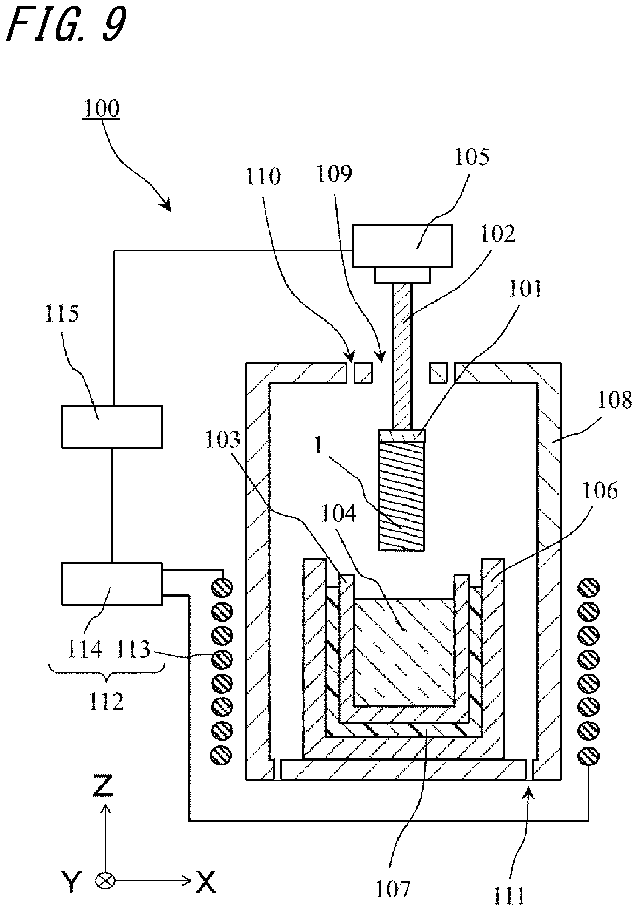

Next, with respect to an example of a crystal production apparatus used for processes of production the silicon carbide crystal ingot 1 and the wafer 2 according to one embodiment of the invention, the present embodiment will be described with reference to FIG. 9. A sectional view of FIG. 9 schematically shows an example of the crystal production apparatus. Meanwhile, the invention is not limited to the present embodiment, and thus various changes, modifications and the like are possible without departing from the scope of the invention.

The crystal production apparatus 100 is an apparatus intended to manufacture the ingot 1. The crystal production apparatus 100 manufactures the ingot 1 by growing a silicon carbide crystal on a lower surface of a seed crystal 101. As shown in FIG. 9, the crystal production apparatus 100 mainly includes a holding member 102 and a crucible 103, the seed crystal 101 is fixed on the holding member 102, and a solution 104 is reserved in the crucible 103. The crystal production apparatus 100 manufactures the ingot 1 on the lower surface of the seed crystal 101 by bringing the lower surface of the seed crystal 101 into contact with the solution 104.

The seed crystal 101 is a silicon carbide crystal serving as a seed for the crystal ingot 1 to be grown in the crystal production apparatus 100. The seed crystal 101 is, for example, of a circular or polygonal planar shape.

The seed crystal 101 is fixed on a lower surface of the holding member 102. The seed crystal 101 is fixed on the holding member 102, for example, with a carbon-containing adhesive (not shown). Also, the seed crystal 101 can be vertically moved by the holding member 102.

The holding member 102 is intended to hold the seed crystal 101. Also, the holding member 102 has a function of bringing the seed crystal 101 into contact with the solution 104 or separating the ingot 1 away from the solution 104. As shown in FIG. 9, the holding member 102 is fixed to a moving mechanism (not shown) of a moving device 105. The moving device 105 has the moving mechanism for vertically moving the holding member 102 fixed to the moving device 105, for example, using a motor. As a result, the holding member 102 is vertically moved by the moving device 105, and thus the seed crystal 101 is vertically moved in accordance with movement of the holding member 102.

The holding member 102 is formed, for example, in a columnar shape. For example, the holding member 102 is formed of a sintered body obtained by sintering a carbon polycrystalline body or carbon. The holding member 102 may be fixed to the moving device 105 in such a state that the holding member 102 can be rotated about an axis vertically extending through the center of a planar shape of the holding member 102. Namely, the holding member 102 may be configured to be rotatable about an axis thereof.

The solution 104 is reserved in the inside of the crucible 103 and has a function of supplying source materials for the ingot 1 to the seed crystal 101. The solution 104 contains the same materials as that of the ingot 1. Namely, because the ingot 1 is a silicon carbide crystal, the solution 104 contains carbon and silicon. In the present embodiment, the solution 104 consists of carbon as a solute dissolved in a silicon solvent. In addition, for reasons of enhancing solubility of carbon and the like, the solution 104 may contain, as additives, one, two or more sorts of metal materials such as neodymium (Nd), tantalum (Ta), scandium (Sc), chrome (Cr), zirconium (Zr), nickel (Ni) or yttrium (Y).

The crucible 103 is intended to contain the solution 104. Also, the crucible 103 serves as a vessel for melting source materials for the ingot 1 therein. The crucible 103 is formed, for example, of graphite. In the present embodiment, a solution obtained by melting silicon in the crucible 103 and then dissolving a part (carbon) of the crucible 103 into the molten silicon is used as the solution 104. In order to reserve the solution 104, the crucible 103 is formed in a recessed shape, for example, having an opening in an upper surface thereof.

In the present embodiment, a solution technique is employed as a method of growing the silicon carbide crystal ingot 1. In the solution technique, deceasing a temperature of the seed crystal 101 or the like is performed while keeping the solution 104 in a metastable state (a state extremely close to a stable state where precipitation and elution of crystal are in thermodynamic equilibrium) on the lower surface of the seed crystal 101, and thus a condition is controlled so that precipitation of crystal can slightly progress relative to elution, thereby growing crystal on the lower surface of the seed crystal 101.

The crucible 103 is disposed in a crucible container 106. The crucible container 106 has a function of holding the crucible 103. A heat retaining material 107 is disposed between the crucible container 106 and the crucible 103. The heat retaining material 107 surrounds the periphery of the crucible 103. The heat retaining material 107 inhibits heat from being emitted from the crucible 103, thereby allowing a temperature distribution in the crucible 103 to approach a uniform state. The crucible 103 may be disposed in the crucible container 106 in such a state that the crucible 103 can be rotated about an axis vertically extending through the center of a bottom surface thereof. Namely, the crucible 103 may be configured to be rotatable about an axis thereof.

The crucible container 106 is disposed in a chamber 108. The chamber 108 isolates a space in which the crystal ingot 1 is grown, from the exterior atmosphere. By having the chamber 108, mixing of extra impurities into the crystal ingot 1 can be reduced. An atmosphere of the interior of the chamber 108 is filled with an inert gas. Thus, the interior of the chamber 108 can be isolated from the exterior. In addition, the crucible container 106 may be supported on a bottom surface of the chamber 108, but a bottom surface of the crucible container 106 may be also supported by a support shaft (not shown) extending downward from the bottom surface through the bottom of the chamber 108.

The chamber 108 has a pass hole 109 allowing the holding member 102 to extend therethrough, a gas supply hole 110 for supplying gas into the chamber 108, and a gas discharge hole 111 for discharging gas from the chamber 108. In addition, the crystal production apparatus 100 has a gas supply means (not shown) for supplying gas into the chamber 108, and thus gas is supplied into the chamber 108 through the gas supply hole 110 by the gas supply means and is discharged through the gas discharge hole 111.

The chamber 108 is formed, for example, in a cylindrical shape. The chamber 108 has a circular lower end portion having, for example, a diameter of 150 mm or more and 1000 mm or less and defining the bottom surface and is set to have, for example, a height of 500 mm or more and 2000 mm or less. The chamber 108 is formed of a material such as stainless steel or insulating quartz. The inert gas to be supplied into the chamber 108 may include, for example, argon (Ar), helium (He) or the like.

The crucible 103 is heated by a heating device 112. The heating device 112 of the present embodiment includes a coil 113 and an alternating current power source 114, and for example is configured to heat the crucible 103 by an induction heating method using electromagnetic waves. Alternatively, the heating device 11 may employ another method like a method that heat generated by a heat-generating resistor of carbon or the like is transferred to the crucible. When a heating device of this heat transfer method is adopted, the heat-generating resistor is disposed (between the crucible 103 and the heat retaining material 107) .

The coil 113 is formed of a conductor and surrounds the periphery of the crucible 103. Specifically, the coil 113 is disposed around the chamber 108 to cylindrically surround the crucible 103. The heating device 112 having the coil 113 has a cylindrical heating portion defined by the coil 113. Alternatively, although in the present embodiment, the coil 113 is disposed around the chamber 108, the coil 113 may be positioned in the interior of the chamber 108.

The alternating current power source 114 is intended to cause an alternating current to flow through the coil 113. As the current flows through the coil 113 and thus an electric field is generated, an induced current is generated in the crucible container 106 located in the electric field. The crucible container 106 is heated by Joule heat of the induced current. Heat of the crucible container 106 is transferred to the crucible 103 through the heat retaining material 107, thereby heating the crucible 103. By adjusting a frequency of the alternating current to facilitate for the induced current to flow through the crucible container 106, a time taken to heat the interior of the crucible 103 to a setting temperature can be reduced or electric power efficiency can be enhanced.

In the present embodiment, the alternating current power source 114 and the moving device 105 are connected to and controlled by a control device 115. Namely, in the crystal production apparatus 100, the control device 115 controls heating of the solution 104 and a temperature thereof, and also carrying in and out for the seed crystal 101 in association therewith. The control device 115 includes a CPU and a storage device such as a memory, and for example is constructed by a known computer.

### <Method of Producing Silicon Carbide Crystal Ingot>

Next, methods of producing the silicon carbide wafer 2 and the silicon carbide crystal ingot 1 according to one embodiment of the invention will be described. Meanwhile, the invention is not limited to the present embodiment, and thus various changes, modifications and the like are possible without departing from the scope of the invention.

The method of producing the silicon carbide crystal ingot according to one embodiment of the invention includes a preparing step, a contact step, a crystal growing step and a pull-apart step.

### (Preparing Step)

A crystal production apparatus 100 is prepared. As described above, the crystal production apparatus 100 mainly includes a holding member 102, a crucible 103, a seed crystal 101 fixed on the holding member 102 and a solution 104 contained in the crucible 103.

The seed crystal 101 is prepared. As the seed crystal 101, there is employed a flat plate-shaped crystal which is formed by performing machining such as cutting, on a mass of silicon carbide crystal produced, for example, by a sublimation method or a solution growth method.

The holding member 102 is prepared. Then, the seed crystal 101 is fixed on the lower surface of the holding member 102. Specifically, a carbon-containing adhesive is applied on the lower surface of the holding member 102. Then, the seed crystal 101 is disposed on the lower surface of the holding member 102 with the carbon-containing adhesive sandwiched therebetween, thereby fixing the seed crystal 101 on the holding member 102.

The crucible 103 is prepared. Then, the crucible 103 is charged with silicon particles which are a silicon source, and the crucible 103 is heated to a temperature above a melting point (1420°C) of silicon, thereby preparing the solution 104. Specifically, carbon (solute) forming the crucible 103 is dissolved in the liquefied silicon (solvent), and thus the solution 104 can be prepared.

### (Contact Step)

The lower surface of the seed crystal 101 is brought into contact with the solution 104. The seed crystal 101 is brought into contact with the solution 104 by moving the holding member 102 in a downward direction. Alternatively, although in the present embodiment, the seed crystal 101 is brought into contact with the solution 104 by moving the seed crystal 101 in the downward direction, the crucible 103 may be moved in an upward direction to bring the seed crystal 101 into contact with the solution 104.

It is sufficient that at least a part of the lower surface of the seed crystal 101 is in contact with a liquid surface of the solution 104. Accordingly, the entire lower surface of the seed crystal 101 may be in contact with the solution 104, or the seed crystal 101 may be in contact with the solution 104 in such a manner that a side surface or an upper surface thereof is immersed in the solution 104.

### (Crystal Growing Step)

Silicon carbide crystal from the solution 104 is grown on the lower surface of the seed crystal 101 brought in contact with the solution 104 in the contact step. Namely, by bringing the lower surface of the seed crystal 101 into contact with the solution 104, a difference in temperature between the lower surface of the seed crystal 101 and the solution 104 near to the lower surface of the seed crystal 101 is occurred. Due to such a difference in temperature, carbon is supersaturated and thus carbon and silicon in the solution 104 are precipitated as a silicon carbide crystal ingot 1 on the lower surface of the seed crystal 101.

Subsequently, the seed crystal 101 is pulled up from the solution 104, so that the ingot 1 is grown in a columnar shape. Meanwhile, by gradually pulling up the seed crystal in the upward direction while adjusting growth rates of the ingot 1 in the horizontal direction and the downward direction, the ingot 1 can be grown while keeping a constant diameter. Specifically, a pulling-up speed of the seed crystal 101 is set, for example, to 50 µm/h or more and 150 µm/h or less.

Growing of the silicon carbide crystal is performed, for example, while dissolving impurities, which become a donor or acceptor, into the solution 104 and also periodically reversing rotation of the seed crystal 101 or the crucible 103. By reversing rotation of the seed crystal 101 or the crucible 103, a flow of the solution 104 can be periodically created during growing of the ingot 1 in such a manner that the solution is descended at a side wall surface of the crucible 103 and then ascended from the center portion of the bottom surface of the crucible 103. As a result, when rotation is reversed, an amount of source materials to be supplied to the growing crystal is increased and also an amount of impurities to be introduced thereto is decreased. Accordingly, it is possible to form the first crystal layers 3 and the second crystal layers 4 while adjusting an impurity concentration.

Growing of the silicon carbide crystal is performed while supplying gaseous impurities which become a donor or acceptor, into the chamber 108 and also periodically increasing or decreasing a supply amount thereof. As a result, a donor or acceptor is introduced into the growing silicon carbide crystal, and thus the concentration gradient portions 5 and the color tone gradient portions 8 can be formed.

Also, a height of a meniscus formed between a growing surface of the ingot 1 and the liquid surface of the solution 104 can be adjusted so that a plurality of recesses 11 and a plurality of protrusions 12 are formed on a side surface of the ingot 1 or the peripheral portion 7 is formed on the ingot 1.

Growing of the silicon carbide crystal may be performed to form the first silicon crystal 3 on the lower surface of the seed crystal 101. By forming the first crystal layer 3 having a small lattice constant on the lower surface of the seed crystal 101, a strain between the growing silicon carbide crystal and the seed crystal 101 can be decreased. As a result, a dislocation caused by a strain between the growing silicon carbide crystal and the seed crystal 101 can be reduced, thereby enhancing quality of the ingot 1.

A temperature of the solution 104 is set, for example, to 1400°C or higher and 2000°C or lower. In a case where the temperature of the solution 104 is varied, a temperature which for example, is obtained by averaging a plurality of temperatures measured during a predetermined period of time may be employed as the temperature of the solution 104. As a method of measuring a temperature of the solution 104, for example, a method of directly measuring a temperature using a thermocouple or a method of indirectly measuring a temperature using a radiation thermometer or the like can be employed.

Alternatively, although in the present embodiment, the seed crystal 101 or the crucible 103 is rotated, the first crystal layers 3 and the second crystal layers 4 may be formed by periodically changing a sort of gas to be introduced and thus changing a partial pressure ratio of a donor or acceptor. Also, by this measure, the concentration gradient portions 5 and the color tone gradient portions 8 may be formed.

Also, in the crystal growing step, the first crystal layers 3 and the second crystal layers 4, the concentration gradient portions 5 or the color tone gradient portions 8 may be formed by periodically changing a height of a meniscus formed between the growing surface of the ingot 1 and the liquid surface of the solution 104 and thus periodically changing a growth rate of the ingot 1.

Further, in the crystal growing step, the first crystal layers 3 and the second crystal layers 4, the concentration gradient portions 5 or the color tone gradient portions 8 may be formed by periodically changing positions of the crucible 103 and the coil 113 or the heat retaining material 107 and thus changing solubility of a donor or acceptor to the solution 104.

### (Pull-apart Step)

After the silicon carbide crystal is grown, the grown silicon carbide crystal ingot 1 is pulled apart from the solution 104, thereby ending growing of the crystal. Then, the grown silicon carbide crystal ingot 1 is cut off from the seed crystal 101. In this way, the ingot 1 can be manufactured.

### <Method of Producing Silicon Carbide Wafer>

Next, a method of producing the silicon carbide wafer 2 according to one embodiment of the invention will be described. Meanwhile, the invention is not limited to the present embodiment, and thus various changes, modifications and the like are possible without departing from the scope of the invention.

The silicon carbide wafer 2 is manufactured by cutting the silicon carbide crystal ingot 1 produced by the above production process. Specifically, the silicon carbide wafer 2 is produced by cutting the ingot 1 into round slices, in which the first crystal layers 3 and the second crystal layers 4 are included. Namely, the silicon carbide wafer 2 in which the first crystal layers 3 and the second crystal layers 4 are included, is produced by cutting the ingot 1 in a direction perpendicular to a longitudinal direction thereof (crystal growth direction). In addition, a distribution of a donor or acceptor concentration or a variation in color tone in the wafer 2 can be adjusted by appropriately adjusting cut sites of the ingot 1.

Cutting of the ingot 1 may be performed so that the second crystal layers 4 are cut. In this case, because the second crystal layers 4 contains contents more than those of the first crystal layers 3 and thus are likely to have a decreased strength, the ingot 1 can be easily cut.

### Reference Signs List

- 1:: Ingot
- 2:: Wafer
- 3:: First crystal layer
- 4:: Second crystal layer
- 5:: Concentration gradient portion
- 6:: Middle portion
- 7:: Peripheral portion
- 8:: Color tone gradient portion
- 9:: First principal surface
- 10:: Second principal surface
- 11:: Recess
- 12:: Protrusion
- 100:: Crystal production apparatus
- 101:: Seed crystal
- 102:: Holding member
- 103:: Crucible
- 104:: Solution
- 105:: Moving device
- 106:: Crucible container
- 107:: Heat retaining material
- 108:: Chamber
- 109:: Pass hole
- 110:: Gas supply hole
- 111:: Gas discharge hole
- 112:: Heating device
- 113:: Coil
- 114:: Alternating current power source
- 115:: Control device

## Claims

1. A silicon carbide crystal ingot, comprising:
first crystal layers and second crystal layers, each being alternately disposed and all containing one of a donor and an acceptor,
wherein a concentration of the donor or the acceptor that at least one of the second crystal layers has is higher than a concentration of the donor or the acceptor that one of the first crystal layers has, the one of the first crystal layers being in contact with the at least one of the second crystal layers.

2. The silicon carbide crystal ingot according to claim 1, further comprising at least one concentration gradient portion in which concentrations of the donor or the acceptor of the first crystal layers and the second crystal layers are increasing in a crystal growth direction.

3. The silicon carbide crystal ingot according to claim 2, wherein the at least one concentration gradient portion comprises two or more concentration gradient portions which are continuous in the crystal growth direction.

4. The silicon carbide crystal ingot according to claim 3, wherein the silicon carbide crystal ingot has a diameter that is increasing in the crystal growth direction,
wherein the silicon carbide crystal ingot further comprises a middle portion and a peripheral portion that is around the middle portion, and
wherein the first crystal layers and the second crystal layers in the peripheral portion are inclined to the crystal growth direction in the middle portion of the silicon carbide crystal ingot.

5. The silicon carbide crystal ingot according to claim 4, wherein a concentration of the donor or the acceptor that the first crystal layers and the second crystal layers in the peripheral portion have is lower than a concentration of the donor or the acceptor that the first crystal layers and the second crystal layers in the middle portion have.

6. The silicon carbide crystal ingot according to any one of claims 1 to 5, wherein each of the first crystal layers and the second crystal layers has a thickness of 3 to 300 µm.

7. The silicon carbide crystal ingot according to any one of claims 2 to 5, wherein the at least one concentration gradient portion in the crystal growth direction has a thickness of 500 to 900 µm.

8. A silicon carbide wafer, comprising:
first crystal layers and second crystal layers, each being alternately disposed and all containing one of a donor and an acceptor,
wherein a concentration of the donor or the acceptor that at least one of the second crystal layers has is higher than a concentration of the donor or the acceptor that one of the first crystal layers has, the one of the first crystal layers being in contact with the at least one of the second crystal layers.

9. The silicon carbide wafer according to claim 8,
wherein a conductivity of the one of the first crystal layers is lower than a conductivity of the at least one of the second crystal layers.

10. The silicon carbide wafer according to claim 8,
wherein a concentration of the donor or the acceptor that one of the first crystal layers and one of the second crystal layers which are located closer to a first principal surface of the silicon carbide wafer have is higher than a concentration of the donor or the acceptor that another one of the first crystal layers and another one of the second crystal layers which are located closer to a second principal surface of the silicon carbide wafer have.

11. The silicon carbide wafer according to claim 10,
wherein concentrations of the donor or the acceptor that the first crystal layers and the second crystal layers have are increasing as a location thereof approaches to the first principal surface.

12. The silicon carbide wafer according to claim 8,
wherein a concentration of the donor or the acceptor that one of the first crystal layers and one of the second crystal layers which are located closer to a first principal surface of the silicon carbide wafer have and a concentration of the donor or the acceptor that one of the first crystal layers and one of the second crystal layers which are located closer to a second principal surface of the silicon carbide wafer have are lower than a concentration of the donor or the acceptor that one of the first crystal layers and one of the second crystal layers which are located in a middle in a thickness direction of the silicon carbide wafer have.

13. A silicon carbide crystal ingot, comprising:
first crystal layers and second crystal layers, each being alternately disposed in a crystal grown direction,
wherein a color tone of at least one of the second crystal layers is darker than a color tone of one of the first crystal layers being in contact with the at least one of the second crystal layers.

14. The silicon carbide crystal ingot according to claim 13, further comprising at least one color tone gradient portion in which color tones of the first crystal layers and the second crystal layers are darkened in a crystal growth direction.

15. The silicon carbide crystal ingot according to claim 14, wherein the at least one color tone gradient portion comprises two or more color tone gradient portions which are continuous in the crystal growth direction.

16. The silicon carbide crystal ingot according to claim 13, wherein the silicon carbide crystal ingot has a diameter that is increasing in the crystal growth direction,
wherein the silicon carbide crystal ingot further comprises a middle portion and a peripheral portion that is around the middle portion, and
wherein the first crystal layers and the second crystal layers in the peripheral portion are inclined to the crystal growth direction in the middle portion of the silicon carbide crystal ingot.

17. The silicon carbide crystal ingot according to claim 16, wherein a color tone of the first crystal layers and the second crystal layers in the peripheral portion is lighter than a color tone of the first crystal layers and the second crystal layers in the middle portion.

18. The silicon carbide crystal ingot according to any one of claims 13 to 17, wherein each of the first crystal layers and the second crystal layers has a thickness of 3 to 300 µm.

19. The silicon carbide crystal ingot according to any one of claims 14 to 17, wherein the at least one color tone gradient portion in the crystal growth direction has a thickness of 500 to 900 µm.

20. A silicon carbide wafer, comprising:
first crystal layers and second crystal layers, each being alternately disposed,
wherein a color tone of at least one of the second crystal layers is darker than a color tone of one of the first crystal layers being in contact with the at least one of the second crystal layers.

21. The silicon carbide wafer according to claim 20,
wherein a color tone of one of the first crystal layers and one of the second crystal layers which are located closer to a first principal surface of the silicon carbide wafer is darker than a color tone of another one of the first crystal layers and another one of the second crystal layers which are located closer to a second principal surface of the silicon carbide wafer.

22. The silicon carbide wafer according to claim 21,
wherein color tones of the first crystal layers and the second crystal layers are darkened as a location thereof approaches to the first principal surface.

23. The silicon carbide wafer according to claim 20,
wherein color tones of the first crystal layers and the second crystal layers are darkened as a location thereof approaches a first principal surface from a second principal surface, suddenly lightened on a way to the first principal surface and then again darkened as the location approaches the first principal surface.

24. The silicon carbide wafer according to any one of claims 20 to 23, wherein each of the first crystal layers and the second crystal layers has a thickness of 3 to 300 µm.
